Europäisches Patentamt

European Patent Office

Office européen des brevets

(11) Numéro de publication: **0 235 399 B1**

## FASCICULE DE BREVET EUROPEEN

(45) Date de publication de fascicule du brevet:
**16.10.91**

(51) Int. Cl.5: **G01R 31/06**

(21) Numéro de dépôt: **86200340.7**

(22) Date de dépôt: **05.03.86**

(54) **Procédé de mesure de l'état électrique de l'isolement entre spires d'un enroulement d'une machine électrique à haute tension.**

(43) Date de publication de la demande:
**09.09.87 Bulletin 87/37**

(45) Mention de la délivrance du brevet:
**16.10.91 Bulletin 91/42**

(84) Etats contractants désignés:
**AT BE CH DE FR GB IT LI LU NL SE**

(56) Documents cités:
**DE-A- 1 513 801**
**DE-A- 1 950 170**
**US-A- 4 540 922**

**IEEE TRANSACTIONS ON POWER APPARA-TUS AND SYSTEMS, vol. PAS-99, no. 4, juillet/août 1980, pages 1557-1566, IEEE, New York, US; H. TERASE et al.: "A new AC current testing method for non-destructive insulation tests"**

**POWER, vol. 116, no. 12, décembre 1972, pages 44,45; P.A. SANGHAVI et al.: "Turn-to-turn testing improves coil life"**

(73) Titulaire: **ACEC ENERGIE S.A.**
**Rue Chapelle Beaussart 80**
**B-6030 Charleroi(BE)**

(72) Inventeur: **Goffaux, Raoul Alfred Alexandre Félicien**
**418/7 Avenue Pastur**
**B-6100 Mont-sur-Marchienne(BE)**

(74) Mandataire: **Bosch, Henry et al**
**Office VAN MALDEREN Boulevard de la Sauvenière, 85/042**
**B-4000 Liège(BE)**

**Description**

La présente invention a pour objet un procédé de mesure de l'état électrique de l'isolement entre spires d'un enroulement d'une machine électrique à haute tension.

Il existe une méthode de mesure de l'état électrique de l'isolement entre spires d'un enroulement à examiner qui consiste à couper les spires, à effectuer la mesure de la résistance d'isolement entre les spires coupées et de réunir ensuite par brasage les parties qui ont été coupées. Le but de l'invention est un procédé de mesure fiable qui ne nécessite pas de telles coupures.

L'invention est caractérisée en ce qu'on mesure la fréquence propre de l'enroulement, en ce que d'une part, on détermine, par spire de l'enroulement à examiner, la résistance $r$, le coefficient de self induction $l$ et la capacité $c$, en ce que d'autre part, on détermine par spire, la résistance d'isolement $R$ entre la spire et la masse, ainsi que la capacité $C$ de la spire par rapport à la masse, en ce qu'on raccorde une des bornes de l'enroulement à examiner d'une part et d'autre part la masse via une résistance variable $r_s$ aux bornes d'un générateur d'impulsions de durée très courte à front raide à haute tension, d'amplitudes variables, en ce qu'on raccorde en parallèle sur la résistance variable $r_s$ un détecteur de l'amortissement d'ondes à la fréquence propre de l'enroulement, en ce qu'on varie la valeur de la résistance variable $r_s$ jusqu'à ce qu'on obtienne une valeur $r_o$ pour laquelle les ondes à la fréquence propre de l'enroulement subissent l'amortissement critique et en ce qu'on calcule à partir des valeurs déterminées des grandeurs ci-dessus la valeur de la résistance d'isolement $R_i$ entre spires pour la valeur de la tension de crête de l'impulsion appliquée.

De préférence, la mesure est faite à l'aide d'une séquence d'impulsions de même amplitude appliquées à une cadence au moins trois fois plus faible que la fréquence propre de l'enroulement.

De préférence la durée des impulsions est plus courte que la durée de deux demi-ondes à la fréquence propre de l'enroulement, mais non négligeable comparée à la constante de temps de charge de l'isolation à haute tension.

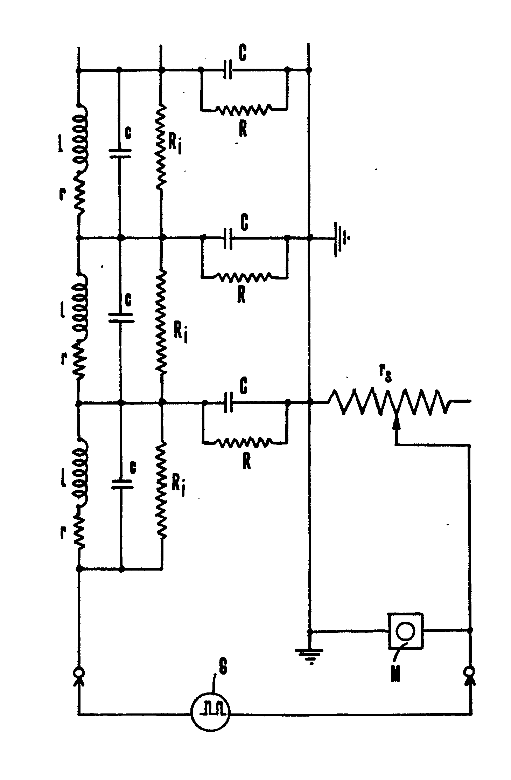

L'invention est expliquée ci-dessous par rapport à un exemple d'exécution en se référant au dessin annexé. L'unique figure du dessin représente un schéma équivalent d'un enroulement d'un rotor d'une machine dynamo-électrique à haute tension, (par exemple 6 kV).

On mesure d'abord la fréquence propre $\omega$ de l'enroulement au moyen de procédés connus. La relation approximative suivante peut être utilisée pour des calculs ultérieurs

$\omega^2 = \frac{1}{lc}$ (l et c étant définis ci-dessous)

On détermine ensuite, à l'aide de moyens connus et la relation ci-dessus, par spire de l'enroulement à examiner, la résistance ohmique $r$, le coefficient de self induction $l$, la capacité entre spires $c$, la résistance d'isolement $R$ de la spire par rapport à la masse du rotor et la capacité $C$ de la spire par rapport à la masse du rotor.

On relie ensuite une extrémité de l'enroulement à examiner à une des bornes d'un générateur $G$ d'impulsions de courte durée à haute tension et on relie la masse du rotor c'est-à-dire l'arbre en série avec une résistance variable $r_s$ à l'autre borne du dit générateur d'impulsions à haute tension. On applique ensuite des impulsions d'amplitude déterminées entre une des bornes de l'enroulement et une des bornes de la résistance variable $r_s$ et on varie la valeur de la résistance variable $r_s$ jusqu'à ce qu'on constate que pour une valeur déterminée $r_o$ la condition d'amortissement critique est atteinte pour les ondes à la fréquence propre de l'enroulement. Cette condition d'amortissement critique peut être vérifiée par exemple au moyen d'un oscilloscope, d'un oscillographe ou d'un fréquencemètre $M$ relié en parallèle sur la résistance $r_s$.

La résistance d'isolement $R_i$ entre spires de l'enroulement à examiner peut être calculée à partir des valeurs déterminées des grandeurs ci-dessus. Cependant, comme déjà le schéma équivalent représenté au dessin annexé constitue une approximation de la réalité, le calcul de la résistance d'isolement $R_i$ conduit à des résultats approximatifs mais de précision suffisante pour permettre l'appréciation de la qualité de l'isolation entre spires de l'enroulement à examiner.

Une formule donnant satisfaction est la suivante :

$$R_i = r_o \cdot \frac{1 + \sqrt{37 + \frac{16 r_o^2 c^2}{3 l c}}}{\frac{4 r_o^2 C}{9 l} + \frac{3c}{C}}$$

Dans le cas d'une bonne isolation

$$\left(R_i > \sqrt{2\frac{l}{c}}\right), \quad R_i$$

n'amortit pratiquement pas l'oscillation à la fréquence propre d'un enroulement ; tout l'amortissement est dû, pratiquement, à la résistance $r_s$ dont la valeur $r_o$ conditionne l'amortissement critique ; dans ce cas $r_o$ est donc très grand.

Au contraire, dans le cas où $R_i$ est médiocre, c'est-à-dire dans le cas d'une isolation douteuse ou mauvaise, l'amortissement des oscillations à la fréquence propre de l'enroulement à examiner est fourni en grande partie par la résistance $R_i$. De ce fait, la contribution à l'amortissement critique qui doit être apporté par la valeur $r_o$ de la résistance $r_s$ est faible. Dans ce cas limite,

$$r_o \frac{2c}{9c} < R_i < 54 \, r_{oc}^C$$

Dans tous les cas, pour qu'une isolation entre spires d'un enroulement puisse être considérée comme acceptable, c'est-à-dire bonne ou au moins moyenne, il est nécessaire que

$$R_i > \frac{l}{r_{\bullet} c}$$

D'autre part, une isolation est moyenne ou même douteuse si $R_i < r_o$.

La mesure de la résistance d'isolement d'un enroulement à examiner est réalisée essentiellement par l'ajustement de la valeur $r_o$ tandis que des impulsions d'une amplitude de tension déterminée sont appliquées.

L'appréciation de l'état électrique d'une isolation doit, en général, prendre en considération l'évolution de sa résistance d'isolement en fonction de la tension appliquée. Plusieurs mesures sont donc nécessaires, en commençant par des impulsions à tension relativement basse pour continuer ensuite avec des impulsions à tension de plus en plus élevée jusqu'à des valeurs susceptibles de se produire dans les conditions d'utilisation les plus dures de la machine.

Le fait de pouvoir déterminer, après chaque prise de mesure, l'état de l'isolement, permet évidemment d'interrompre une série de mesures dès qu'on s'aperçoit que les mesures elles-mêmes pourraient constituer un danger pour l'isolation d'un enroulement.

Les enroulements d'une machine sont examinés chaque phase isolément, si le neutre est accessible. Si le neutre n'est pas accessible, on court-circuite deux des phases de manière que l'impédance totale soit égale à 3/2 l'impédance d'une seule phase. Les amplitudes des impulsions appliquées à chacune des phases dépendent de la différence de tension apparaissant à la tension nominale de la machine en service aux bornes d'une section de l'enroulement. On choisit, de préférence comme valeur de l'amplitude de l'impulsion une tension égale à au moins 3 fois cette différence de tension et au maximum 4 kV. Ces valeurs sont considérées comme applicables pour des stators de machines de 3 à 20 kV. Pour des rotors de telles machines la tension maximum est limitée à une valeur nettement moindre, par exemple 1500 V.

## Revendications

1. Procédé de mesure de l'état électrique de l'isolement entre spires d'un enroulement d'une machine électrique à haute tension, caractérisé en ce qu'on mesure la fréquence propre de l'enroulement, en ce que d'une part, on détermine, par spire de l'enroulement à examiner la résistance r, le coëfficient de self induction l et la capacité c, en ce que d'autre part on détermine par spire la résistance d'isolement R entre spire et la masse, ainsi que la capacité C de la spire par rapport à la masse, en ce qu'on raccorde une des bornes de l'enroulement à examiner d'une part et d'autre part la masse via une résistance variable $r_s$ aux bornes d'un générateur d'impulsions de durée très courte à front raide à haute tension d'amplitudes variables, en ce qu'on raccorde en parallèle sur la résistance variable $r_s$ un détecteur de l'amortissement d'ondes à la fréquence propre de l'enroulement, en ce qu'on varie la valeur de la résistance variable $r_s$ jusqu'à ce qu'on obtienne une valeur $r_o$ pour laquelle les ondes à la fréquence propre de l'enroulement subissent l'amortissement critique et en ce qu'on calcule à partir des valeurs déterminées des grandeurs ci-dessus la valeur de la résistance d'isolement Ri entre spires pour la valeur de la tension de crête de l'impulsion appliquée.

2. Procédé suivant la revendication 1, caractérisé en ce qu'on applique à l'enroulement à examiner mis en série avec la résistance $r_s$ des séquences d'impulsions à amplitude constante, amplitude variable d'une séquence à l'autre, à une cadence au moins trois fois plus faible que la fréquence propre de l'enroulement.

3. Procédé suivant une des revendications 1 ou 2, caractérisé en ce qu'on calcule la résistance d'isolement entre spires par la formule

$$R_i = r_{\bullet} \frac{1 + \sqrt{37 + \frac{16 r_{\bullet}^2 c^2}{3 l c}}}{\frac{4 r_{\bullet}^2 C}{9 l} + \frac{3c}{C}}$$

l'ajustement de la valeur $r_o$ ayant été effectué pour des impulsions d'une amplitude de valeur prédéterminée.

4. Procédé suivant une des revendications précédentes, caractérisé en ce qu'on détermine l'évolution de la résistance d'isolement d'un enroulement à examiner pour des amplitudes d'impulsions à valeurs croissantes.

## Claims

1. Method of measuring the electrical state of the interturn insulation of a winding of a high-voltage electrical machine,
characterised in that the natural frequency of the winding is measured, in that on the one hand, per turn of the winding to be examined, the resistance r, the coefficient of self-induction 1 and the capacitance c are determined, in that on the other hand, per turn, the turn-to-earth insulation resistance R, as well as the capacitance C of the turn relative to earth are determined, in that one of the terminals of the winding to be examined on the one hand, and on the other hand earth, are connected up via a variable resistor $r_s$ to the terminals of a generator of variable amplitude, high-voltage, steep-fronted very short duration pulses, in that a detector of the damping of waves at the natural frequency of the winding is connected up in parallel with the variable resistor $r_s$, in that the value of the variable resistor $r_s$ is varied until a value $r_0$ is obtained for which the waves at the natural frequency of the winding undergo critical damping, and in that on the basis of the determined values of the above quantities the value of the interturn insulation resistance $R_i$ is calculated for the value of the peak voltage of the pulse applied.

2. Method according to Claim 1, characterised in that constant-amplitude pulse sequences, variable amplitude from one sequence to the next, are applied to the winding to be examined placed in series with the resistor $r_s$, at a rate at least three times lower than the natural frequency of the winding.

3. Method according to one of Claims 1 or 2, characterised in that the interturn insulation resistance is calculated through the formula

$$R_i = r \cdot \frac{1 + \sqrt{37 + \frac{16 r_0^2 c^2}{3 l c}}}{\frac{4 r_0^2 C}{9 l} + \frac{3c}{C}}$$

the setting of the value $r_0$ having been performed for pulses with an amplitude of predetermined value.

4. Method according to one of the preceding claims, characterised in that the change is determined in the insulation resistance of a winding to be examined for pulse amplitudes with increasing values.

## Patentansprüche

1. Verfahren zum Messen des elektrischen Zustandes der Isolierung zwischen Windungen einer Wicklung einer elektrischen Hochspannungsmaschine,
**dadurch gekennzeichnet, daß** die Eigenfrequenz der Wicklung gemessen wird, **daß** einerseits pro Windung der zu prüfenden Wicklung der Widerstand r, der Selbst-Selbstinduktionskoeffizient 1, und die Kapazität c bestimmt wird, **daß** andererseits pro Windung der Isolationswiderstand R zwischen Windung und Masse, sowie die Kapazität C der Windung gegenüber Masse bestimmt wird, **daß** einerseits eine der Klemmen der zu prüfenden Wicklung, und andererseits, über einen variablen Widerstand $r_s$, die Masse mit den Klemmen eines Impulsgenerators verbunden wird, der Hochspannungsimpulse mit variabler Amplitude von sehr kurzer Dauer und mit steiler Flanke erzeugt, **daß** parallel zu dem variablen Widerstand $r_s$ ein Sensor zur Messung der Dämpfung von Wellen mit der Eigenfrequenz der Wicklung angeschlossen wird, **daß** der Wert des variablen Widerstandes $r_s$ verändert wird, bis ein Wert $r_0$ erhalten wird, bei dem die Wellen mit der Eigenfrequenz der Wicklung der kritschen Dämpfung unterworfen werden, **und daß** aufgrund der für die obigen Größen bestimmten Werte der Isolationswiderstand $R_i$ zwischen Windungen für den Wert der Spitzenspannung des auf die Wicklung gegebenen Impulses berechnet wird.

2. Verfahren gemäß Anspruch 1, **dadurch gekennzeichnet, daß** auf die mit dem Widerstand in Serie geschaltete, zu prüfende Wicklung Impulsfolgen mit konstanter, von Folge zu Folge variabler Amplitude gegeben werden, mit einer Frequenz, die höchstens ein Drittel der Eigenfrequenz der Wicklung beträgt.

3. Verfahren gemäß einem der Ansprüche 1 oder 2, **dadurch gekennzeichnet, daß** der Isolationswiderstand zwischen Windungen berechnet wird nach der Formel

$$R_i = r_o \frac{1 + \sqrt{37 + \dfrac{16 r_o^2 C^2}{31 c}}}{\dfrac{4 r_o^2 C}{91} + \dfrac{3c}{C}}$$

wobei die Anpassung des Wertes $r_o$ für Impulse mit einer Amplitude von vorgegebenem Wert vorgenommen wurde.

4. Verfahren gemäß einem der vorhergehenden Ansprüche, **dadurch gekennzeichnet, daß** der Isolationswiderstand einer zu prüfenden Wicklung für Impulsamplituden mit ansteigenden Werten bestimmt wird.